# EUROPEAN PATENT APPLICATION

(11) **EP 1 494 285 A1**
(43) Date of publication of application: **05.01.2005**
(21) Application number: 03715470.5
(22) Date of filing: 27.03.2003
(51) Int. Cl.: H01L 25/16, H03H 9/10, H03H 3/02, H03B 5/32

(54) **CIRCUIT MODULE AND METHOD FOR MANUFACTURING THE SAME**

(30) Priority: 05.04.2002 JP 2002103688
(71) Applicant: Murata Manufacturing Co., Ltd., Nagaokakyo-shi Kyoto-fu 617-8555 (JP)
(72) Inventor: MORIYASU, Akiyoshi Murata Manufacturing co. ltd., Kyoto 617-8555 (JP); HARADA, Jun Murata Manufacturing co. ltd., Kyoto 617-8555 (JP); TAKAGI, Hiroshi Murata Manufacturing co. ltd., Kyoto 617-8555 (JP); YAMAMOTO, Yuki Murata Manufacturing co. ltd., Kyoto 617-8555 (JP)
(74) Representative: Schoppe, Fritz, Dipl.-Ing.
(86) International application number: PCT/JP2003/003788
(87) International publication number: WO 2003/085739

(57) **Abstract**

A board 11 having a quartz crystal 13 housed in a cavity 12 is prepared. Chips 14a to 14c are mounted on wiring conductors 20 disposed on a second main surface 11b of the board 11. An epoxy resin prepreg sheet 15a is stacked on the second main surface 11b of the board 11, heated, and pressure-bonded to form a resin layer 15 on the second main surface of the board 11. Accordingly, a circuit module that can be miniaturized in two dimensions and that ensures reliability and flexibility in establishing external connections and a method for manufacturing the same are provided.

## Description

### Technical Field

The present invention relates to a circuit module which includes a board with surface-mounted components disposed thereon and which constitutes, as a whole, a predetermined electronic circuit and to a method for manufacturing the same, and more particularly relates to a circuit module, such as a piezoelectric vibrator or a crystal oscillator, and to a method for manufacturing the same.

### Background Art

Recently, due to the miniaturization of electronic devices, such as cellular phones, a circuit module including a plurality of integrated surface-mounted components, instead of individual surface-mounted components, has been mounted on a mounting board, such as a printed circuit board.

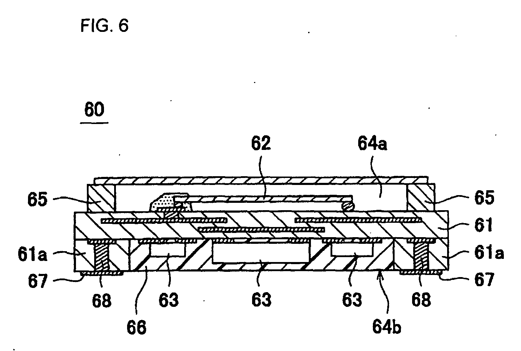

Such a circuit module is disclosed in, for example, Japanese Unexamined Patent Application Publication No. 2000-151283. A circuit module 60 is a temperature-compensated crystal oscillator. As schematically shown in Fig. 6, the circuit module 60 includes a board 61, a quartz crystal 62 mounted on the top surface of the board 61, and surface-mounted components 63, such as an IC chip and a capacitor, which are mounted on the bottom surface of the board 61.

In the circuit module 60, cavities 64a and 64b are provided to accommodate the quartz crystal 62 and the surface-mounted components 63, respectively. The cavity 64a is a space defined by the top surface of the board 61 and a seal ring 65 disposed on the periphery of the top surface of the board 61. The cavity 64b is a space defined by the bottom surface of the board 61 and a board wall 61a disposed on the periphery of the bottom surface of the board 61. The cavity 64b is molded with a resin 66. On the surface of the board wall 61a, terminal electrodes 67 for establishing external connections are disposed. Inside the board wall 61a, via conductors 68 to be connected to the terminal electrodes 67 are disposed.

To further miniaturize the above described circuit module 60, the planar area of the circuit module 60 may be reduced. To this end, the planar area of the cavity 64b or the width of the board wall 61a must be reduced.

There is a limit to reducing the planar area of the cavity 64b. First, it is difficult to further miniaturize the surface-mounted components 63 or to reduce the number of the surface-mounted components 63. Second, due to mounting technical problems, the surface-mounted components 63 must be mounted in the cavity 64b with a predetermined gap from the board wall 61a.

When the width of the board wall 61a is excessively reduced, the mechanical strength of the board wall 61a may be reduced. This may in turn reduce the reliability of establishing external connections. In accordance with the width of the board wall 61a, the area of the terminal electrodes 67 must be reduced. A wiring pattern of a wiring board connected to the terminal electrodes 67 may be restricted.

In accordance with the above-described circumstances, an object of the present invention is to provide a circuit module that may be miniaturized in two dimensions and that ensures reliability and flexibility in establishing external connections and to provide a method for manufacturing the same.

### Disclosure of Invention

A circuit module according to the present invention includes a board having a first main surface and a second main surface that faces the first main surface; a first surface-mounted component housed in a cavity formed in the first main surface of the board; a second surface-mounted component disposed on the second main surface of the board; a resin layer disposed on the second main surface of the board so that the second surface-mounted component is embedded therein; a wiring conductor disposed on the second main surface of the board; a terminal electrode for establishing an external connection, the terminal electrode being disposed on the surface of the resin layer; and a via conductor for connecting the wiring conductor to the terminal electrode, the via conductor being disposed inside the resin layer.

In the circuit module according to the present invention, the first surface-mounted component may be a piezoelectric vibrator, and the piezoelectric vibrator and the second surface-mounted component may constitute an oscillation circuit.

In the circuit module according to the present invention, the first surface-mounted component may be a quartz crystal, and the quartz crystal and the second surface-mounted component may constitute an oscillation circuit.

In the circuit module according to the present invention, the first surface-mounted component may be a quartz crystal, and the quartz crystal and a portion of the second surface-mounted component may constitute an oscillation circuit. Another portion of the second surface-mounted component may constitute a temperature-compensated circuit.

In the circuit module according to the present invention, the board may be a ceramic multilayer board including a plurality of ceramic layers stacked on one another.

A circuit module manufacturing method according to the present invention includes a first step of preparing a board having a first main surface with a cavity and a second main surface that faces the first main surface; a step of housing a first surface-mounted component in the cavity; a second step of disposing a second surface-mounted component on the second main surface; a third step of forming a resin layer on the second main surface of the board so that the second surface-mounted component is embedded therein; and a fourth step of disposing a terminal electrode for establishing an external connection on the surface of the resin layer.

In the circuit module manufacturing method according to the present invention, preferably the third step includes a step of producing a prepreg sheet including a thermosetting resin; a step of stacking the prepreg sheet on the second main surface, with the second surface-mounted component disposed therebetween; and a step of heating and pressure-bonding the prepreg sheet and forming, on the second main surface, the resin layer in which the second surface-mounted component is embedded.

In the circuit module manufacturing method according to the present invention, preferably the fourth step includes a step of connecting the terminal electrode to an electrode disposed on the second main surface of the board through a via conductor that penetrates through the resin layer. More specifically, preferably a metal film is formed on one main surface of the prepreg sheet; a through hole that penetrates through the prepreg sheet and the metal film is formed; the through hole is filled with a conductive resin that becomes the via conductor; the prepreg sheet is heated from the other main surface thereof and pressure-bonded to the second main surface of the board; and the metal film is patterned to form the terminal electrode to be connected to the electrode disposed on the second main surface.

In the circuit module manufacturing method according to the present invention, preferably the third step includes a step of coating the second main surface with an uncured thermosetting resin and embedding the second surface-mounted component in the thermosetting resin; and a step of heating the thermosetting resin to form, on the second main surface, the resin layer in which the second surface-mounted component is embedded.

In the circuit module manufacturing method according to the present invention, preferably the fourth step includes a step of connecting the terminal electrode to an electrode disposed on the second main surface of the board through a via conductor that penetrates through the resin layer. More specifically, preferably a through hole that is deep enough to reach the electrode disposed on the second main surface of the board and that penetrates through the thermosetting resin is formed; the through hole is filled with a conductive resin that becomes the via conductor; a metal film is formed on the surface of the thermosetting resin so as to be connected to the conductive resin exposed through the through hole; and the metal film is patterned to form the terminal electrode to be connected to the electrode disposed on the second main surface.

### Brief Description of the Drawings

Fig. 1(a) is a perspective view of a temperature-compensated crystal oscillator 10 (circuit module) according to a first embodiment, and Fig. 1(b) is a sectional view taken along line A-A of Fig. 1(a).
Fig. 2 is a circuit diagram of an example of the circuit configuration of the temperature-compensated crystal oscillator 10 according to the first embodiment.
Fig. 3(a) to (e) includes sectional views showing the steps of a method for manufacturing the temperature-compensated crystal oscillator 10 according to the first embodiment.
Fig. 4 is a sectional view of a temperature-compensated crystal oscillator 10a according to a second embodiment.
Fig. 5(a) to (e) includes sectional views showing the steps of a method for manufacturing the temperature-compensated crystal oscillator 10a according to the second embodiment.
Fig. 6 is a sectional view of a known crystal oscillator.

### Best Mode for Carrying Out the Invention

Embodiments of the present invention will now be described in detail to illustrate features of the present invention.

### <First Embodiment>

### (Structure of Circuit Module)

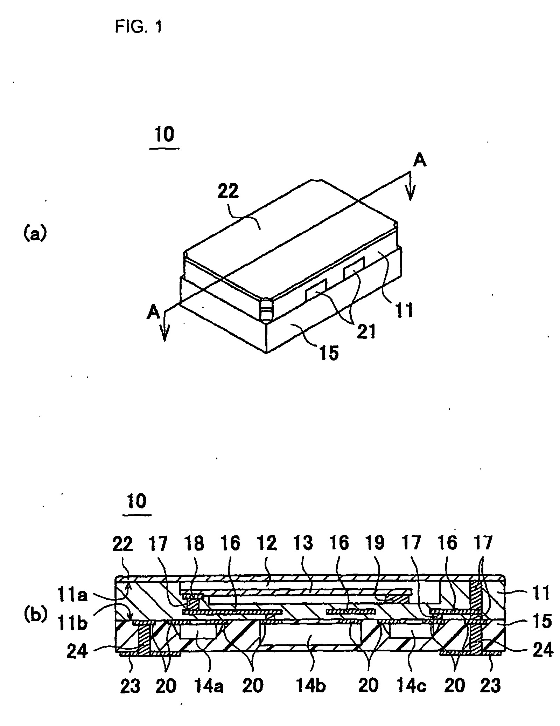

Fig. 1(a) is a perspective view of a temperature-compensated crystal oscillator serving as a circuit module according to the present invention, and Fig. 1(b) is a sectional view taken along line A-A of Fig. 1(a).

As shown in Fig. 1(a) and (b), a temperature-compensated crystal oscillator 10 includes a board 11, a quartz crystal 13 housed in a cavity 12 formed in a first main surface 11a of the board 11, surface-mounted chips 14a to 14c disposed on a second main surface 11b of the board 11, and a resin layer 15 disposed on the second main surface 11b of the board 11 so that the chips 14a to 14c may be embedded therein.

Inside the board 11, inner conductors 16 and first via conductors 17 are disposed. On the bottom surface of the cavity 12, a pad electrode 18 to be connected to the quartz crystal 13 and a bump 19 for holding one end of the quartz crystal 13 are disposed. On the second main surface 11b of the board 11, wiring conductors 20 to be connected to the chips 14a to 14c are disposed. As shown in Fig. 1(a), side electrodes 21 are disposed on a side surface of the board 11. Although not shown in the drawing, the side electrodes 21 are connected to the wiring conductors 20. On the first main surface 11a of the board 11, a shield 22 is disposed closing the cavity 12. In other words, the board 11 and the shield 22 constitute a so-called package.

The board 11 is, for example, a ceramic multilayer board or a resin board. Although a sidewall portion and a flat plate portion of the board 11 are integrated with each other in this embodiment, they may be made of different materials.

An appropriate oscillation frequency of the quartz crystal 13 is selected in accordance with the purpose of use. Although the quartz crystal 13 is housed in the cavity 12 in the present invention, other surface-mounted components may be housed in the cavity 12. In particular, it is preferable that a surface-mounted component, such as a piezoelectric element, that may malfunction when embedded in the resin layer 15 be housed in the cavity 12.

The pad electrode 18, the wiring conductors 20, and the side electrodes 21 may be made of metals, such as Ag, Cu, Au, Ag-Pt, and Ag-Pd. The bump 19 may be, for example, an Au bump or a solder bump. The shield 22 may be made of, for example, metal materials, such as Kovar and 42 alloy.

On the surface of the resin layer 15, terminal electrodes 23 for establishing external connections are disposed. Inside the resin layer 15, second via conductors 24 to be connected to the terminal electrodes 23 and the wiring conductors 20 are disposed. A portion of the surface of the resin layer 15, on which the terminal electrodes 23 are not disposed, may be covered with a protective film made of an insulating material.

The resin layer 15 may be made of, for example, a mixture of an inorganic filler and a thermosetting resin. The inorganic filler may include, for example, Al₂O₃, SiO₂, and TiO₂. Using such an inorganic filler, the heat dissipation characteristics are improved, and the fluidity and the filling characteristics of the resin layer 15 become more controllable. The thermosetting resin may include, for example, an epoxy resin, a phenolic resin, and a cyanate resin. The terminal electrodes 23 may be made of metals, such as Ag, Cu, Au, Ag-Pt, and Ag-Pd. The second via conductors 24 may be made of a conductive resin composition of metal particles, such as Au, Ag, Cu, and Ni, and a thermosetting resin, such as an epoxy resin, a phenolic resin, and a cyanate resin.

The chips 14a to 14c serve part of a circuit of the temperature-compensated crystal oscillator 10. The chips 14a to 14c may include, for example, active elements, such as a transistor, an LC, and an LSI, and passive elements, such as a capacitor, a resistor, or a thermistor. A drawing of terminal electrodes of the chips 14a to 14c is omitted.

When an integrated circuit component, such as an IC or LSI, is used as one of the chips 14a to 14c, this integrated circuit component performs a function of preventing the temperature frequency characteristics of the quartz crystal 13, which are indicated by a three-dimensional curve, from fluctuating due to ambient temperature.

Specifically, the integrated circuit component includes an inverter constituting an oscillation circuit, a capacitor, a resistor, a memory storing necessary temperature compensation data for flattening the temperature frequency characteristics of the quartz crystal 13, a temperature sensor for sensing ambient temperature, a varicap diode, DA converting means for converting voltage to be applied to the varicap diode on the basis of the temperature compensation data, and a processor for controlling the operation of these components.

The integrated circuit component further includes, for example, a Vcc terminal to which a power supply voltage is fed, a GND terminal at a ground potential, a quarts crystal connection terminal to be connected to the quartz crystal 13, an OUT terminal for outputting oscillation, a Vcont terminal for enabling external frequency adjustment, and a data writing terminal for writing the temperature compensation data. Of these components, the Vcc terminal, the GND terminal, the OUT terminal, and the Vcont terminal are electrically connected to the terminal electrodes 23 for establishing external connections via the second via conductors 24 disposed inside the resin layer 15. The data writing terminal is electrically connected to the side electrodes 21 disposed on the side surface of the board 11 via the wiring conductors 20.

A method for mounting an active element, such as the integrated circuit component, includes, for example, a method of forming gold or solder bumps on the wiring conductors 20 and performing ultrasonic bonding. To improve the bonding strength of the integrated circuit component to the board 11, a space between the integrated circuit component and the board 11 may be filled with an underfill resin, such as an epoxy resin.

In contrast, when a capacitor is used as one of the chips 14a to 14c, the capacitor performs a function of eliminating high-frequency noise parasitic on the power supply voltage and eliminating noise components included in a signal output from the temperature-compensated crystal oscillator 10.

A method for mounting a passive element, such as the capacitor, includes, for example, adhesive bonding using a conductive adhesive or soldering.

### (Circuit Configuration of Circuit Module)

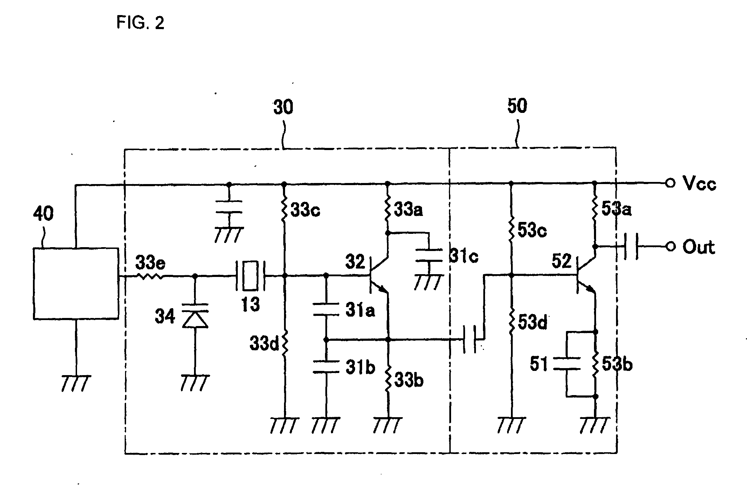

Fig. 2 is a circuit diagram of an example of the circuit configuration of the temperature-compensated crystal oscillator 10. As shown in Fig. 2, this circuit includes an oscillation circuit 30, a compensated-voltage generating circuit 40, and a buffer amplifier circuit 50.

The oscillation circuit 30 is a common-collector Colpitts oscillation circuit including the quartz crystal 13, a transistor 32 whose base and emitter are interconnected by a capacitor 31a, resistors 33a to 33e, capacitors 31b and 31c, and the like.

In the oscillation circuit 30, the resistor 33a and the capacitor 31c apply a DC component of power supply voltage Vcc to the collector of the transistor 32. The emitter of the transistor 32 is connected to a ground via the resistor 33b. The resistors 33c and 33d divide the power supply voltage Vcc and apply a partial voltage to the base of the transistor 32.

In the oscillation circuit 30, a varicap diode 34 is connected between the ground and the terminal electrode of the quartz crystal 13, and the output voltage of the compensated-voltage generating circuit 40 is input via the resistor 33e to the quartz crystal 13.

The compensated-voltage generating circuit 40 cancels out the temperature frequency characteristics of the quartz crystal 13 by changing the characteristics of the output voltage to be applied to the quartz crystal 13 in accordance with changes in the ambient temperature and hence stabilizes the frequency of the quartz crystal 13. The compensated-voltage generating circuit 40 includes a resistor, an NTC thermistor, etc (not shown).

The buffer amplifier circuit 50 includes a capacitor 51, a transistor 52, resistors 53a to 53d, and the like. In the buffer amplifier circuit 50, the power supply voltage Vcc is input via the resistor 53a to the collector of the transistor 52. The emitter of the transistor 52 is connected to the ground via the resistor 53b and the capacitor 51. The resistors 53c and 53d divide the power supply voltage Vcc and apply a partial voltage to the base of the transistor 52.

In this circuit, the quartz crystal 13 is caused to vibrate by the oscillation circuit 30, and the load capacitance of the quartz crystal 13 is controlled by the voltage applied to the varicap diode 34, thereby controlling the oscillation frequency. The oscillation output is taken from the emitter of the transistor 52, amplified by the buffer amplifier circuit 50, and output from the collector of the transistor 52. Fluctuations in the output frequency due to temperature are compensated for by the compensated-voltage generating circuit 40.

### (Method for Manufacturing Circuit Module)

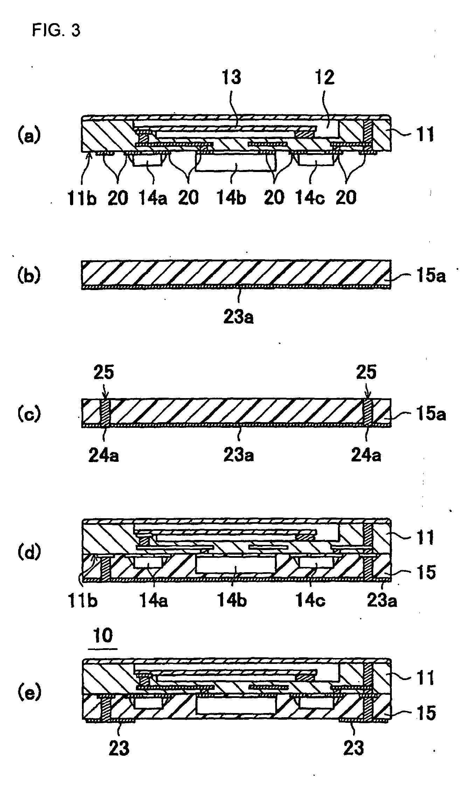

The temperature-compensated crystal oscillator 10 shown in Fig. 1 is manufactured by, for example, the following method. As shown in Fig. 3(a), the board 11 having the quartz crystal 13 housed in the cavity 12 is prepared. The chips 14a to 14c are mounted on the wiring conductors 20 disposed on the second main surface 11b of the board 11.

At the same time, as shown in Fig. 3(b), an epoxy resin prepreg sheet 15a with copper foil 23a disposed on its main surface (the resin layer 15 prior to being cured) is prepared.

Subsequently, as shown in Fig. 3(c), through holes 25, which are 150 µm in diameter, are formed in the epoxy resin prepreg sheet 15a. The through holes 25 are filled with a conductive resin 24a (second via conductors 24 prior to being cured) by screen printing.

Subsequently, as shown in Fig. 3(d), the epoxy resin prepreg sheet 15a is stacked on the second main surface 11b of the board 11, with the chips 14a to 14c disposed therebetween, and pressure-bonded at 160°C for 60 minutes by a vacuum press. As a result, the epoxy resin prepreg sheet 15a is heat-cured to form the resin layer 15.

Subsequently, as shown in Fig. 3(e), an unnecessary portion of the copper foil 23a is removed by, for example, photolithography or etching, to form the terminal electrodes 23.

### <Second Embodiment>

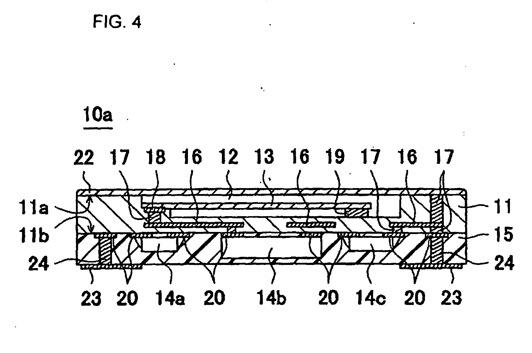

Fig. 4 is a sectional view of a temperature-compensated crystal oscillator serving as a circuit module according to the present invention. The structure of a temperature-compensated crystal oscillator 10a is the same as that of the temperature-compensated crystal oscillator 10 shown in Fig. 1 except that the shape of the terminal electrodes 23 is different. In the temperature-compensated crystal oscillator 10a, the second via conductors 24 do not penetrate through the terminal electrodes 23.

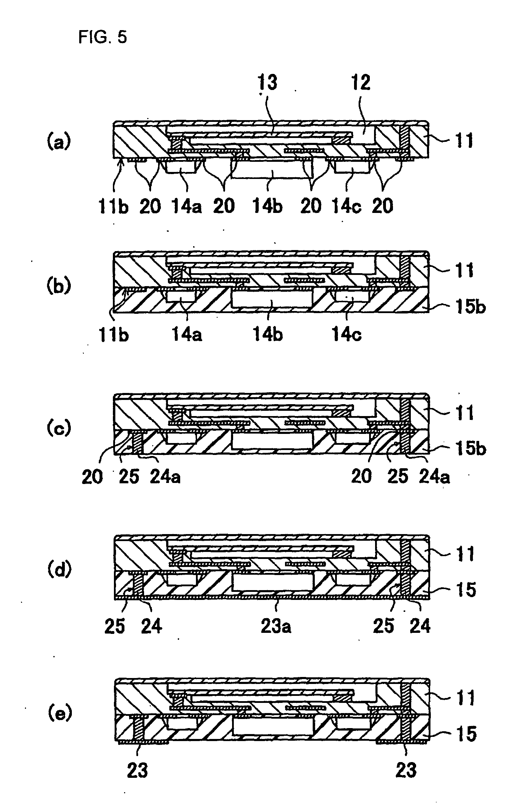

The temperature-compensated crystal oscillator 10a shown in Fig. 4 is manufactured by, for example, the following method. As shown in Fig. 5(a), the board 11 having the quartz crystal 13 housed in the cavity 12 is prepared. The chips 14a to 14c are mounted on the wiring conductors 20 disposed on the second main surface 11b of the board 11.

Subsequently, as shown in Fig. 5(b), the second main surface 11b of the board 11 is coated with an epoxy resin material 15b using a coater. This workpiece is heated in a vacuum oven at 100°C for approximately 10 minutes. As a result, gaps between the chips 14a to 14c and the second main surface 11b are filled with the epoxy resin material 15b. In this case, the epoxy resin material 15b is only semi-cured.

The board 11 coated with the epoxy resin material 15b is taken out from the vacuum oven. As shown in Fig. 5(c), through holes 25, which are 150 µm in diameter and which are deep enough to reach the wiring conductors 20, are formed in the epoxy resin material 15b. The through holes 25 are filled with the conductive resin 24a (second via conductors 24 prior to being cured) by screen printing.

Subsequently, electrolytic copper foil 23a with one side being roughed is stacked on the epoxy resin material 15b and heated by a vacuum press at 160°C for 60 minutes to pressure-bond the copper foil 23a to the epoxy resin material 15b, thereby curing the epoxy resin material 15b. As a result, as shown in Fig. 5(d), the resin layer 15 is formed, and the conductive resin 24a filling the through holes 25 is cured to form the second via conductors 24.

Subsequently, as shown in Fig. 5(e), an unnecessary portion of the copper foil 23a is removed by, for example, photolithography or etching, to form the terminal electrodes 23.

As described above, according to the circuit module of the present invention, the surface-mounted component may be mounted on one main surface of the board even when there is no board sidewall. At the same time, this main surface may have a function of establishing external connections. Since miniaturization of the circuit module is not restricted by a board sidewall, the circuit module can be miniaturized. Since the second via conductors to be connected to the terminal electrodes for establishing external connections are disposed inside the resin layer, which is structurally stable, the reliability of establishing external connections is high. Since the terminal electrodes for establishing external connections are disposed on the surface of the resin layer having a wide area, the terminal electrodes are easily aligned with a wiring pattern of a wiring board.

According to the circuit module manufacturing method of the present invention, the prepreg sheet is pressure-bonded directly to the board, or the board is coated directly with the resin material. As a result, the circuit module is easily manufactured.

### Industrial Applicability

As described above, a circuit module of the present invention and a method for manufacturing the same are useful in a circuit module that includes a surface-mounted component and that constitutes a predetermined electronic circuit and particularly suitable for a circuit module having a piezoelectric vibrator or a quartz crystal.

## Claims

1. A circuit module comprising:
a board having a first main surface and a second main surface that faces the first main surface;
a first surface-mounted component housed in a cavity formed in the first main surface of the board;
a second surface-mounted component disposed on the second main surface of the board;
a resin layer disposed on the second main surface of the board so that the second surface-mounted component is embedded therein;
a wiring conductor disposed on the second main surface of the board;
a terminal electrode for establishing an external connection, the terminal electrode being disposed on the surface of the resin layer; and
a via conductor for connecting the wiring conductor to the terminal electrode, the via conductor being disposed inside the resin layer.

2. A circuit module according to claim 1, wherein the first surface-mounted component is a piezoelectric vibrator, and the piezoelectric vibrator and the second surface-mounted component constitute an oscillation circuit.

3. A circuit module according to claim 1, wherein the first surface-mounted component is a quartz crystal, and the quartz crystal and the second surface-mounted component constitute an oscillation circuit.

4. A circuit module according to claim 1, wherein the first surface-mounted component is a quartz crystal, and the quartz crystal and a portion of the second surface-mounted component constitute an oscillation circuit; and another portion of the second surface-mounted component constitutes a temperature-compensated circuit.

5. A circuit module according to claim 1, wherein the board is a ceramic multilayer board including a plurality of ceramic layers stacked on one another.

6. A circuit module manufacturing method comprising:
a first step of preparing a board having a first main surface with a cavity and a second main surface that faces the first main surface;
a step of housing a first surface-mounted component in the cavity;
a second step of disposing a second surface-mounted component on the second main surface;
a third step of forming a resin layer on the second main surface of the board so that the second surface-mounted component is embedded therein; and
a fourth step of disposing a terminal electrode for establishing an external connection on the surface of the resin layer.

7. A circuit module manufacturing method according to claim 6, wherein the third step includes:
a step of producing a prepreg sheet including a thermosetting resin;
a step of stacking the prepreg sheet on the second main surface with the second surface-mounted component disposed therebetween; and
a step of heating and pressure-bonding the prepreg sheet and forming, on the second main surface, the resin layer in which the second surface-mounted component is embedded.

8. A circuit module manufacturing method according to claim 7, wherein the fourth step includes a step of connecting the terminal electrode to an electrode disposed on the second main surface of the board through a via conductor that penetrates through the resin layer.

9. A circuit module manufacturing method according to claim 8, wherein a metal film is formed on one main surface of the prepreg sheet; a through hole that penetrates through the prepreg sheet and the metal film is formed; the through hole is filled with a conductive resin that becomes the via conductor; the prepreg sheet is heated from the other main surface thereof and pressure-bonded to the second main surface of the board; and the metal film is patterned to form the terminal electrode to be connected to the electrode disposed on the second main surface.

10. A circuit module manufacturing method according to claim 6, wherein the third step includes:
a step of coating the second main surface with an uncured thermosetting resin and embedding the second surface-mounted component in the thermosetting resin; and
a step of heating the thermosetting resin to form, on the second main surface, the resin layer in which the second surface-mounted component is embedded.

11. A circuit module manufacturing method according to claim 10, wherein the fourth step includes a step of connecting the terminal electrode to an electrode disposed on the second main surface of the board through a via conductor that penetrates through the resin layer.

12. A circuit module manufacturing method according to claim 11, wherein a through hole that is deep enough to reach the electrode disposed on the second main surface of the board and that penetrates through the thermosetting resin is formed; the through hole is filled with a conductive resin that becomes the via conductor; a metal film is formed on the surface of the thermosetting resin so as to be connected to the conductive resin exposed through the through hole; and the metal film is patterned to form the terminal electrode to be connected to the electrode disposed on the second main surface.
